# EUROPEAN PATENT APPLICATION

(11) **EP 3 057 384 A1**
(43) Date of publication of application: **17.08.2016**
(21) Application number: 16153657.8
(22) Date of filing: 01.02.2016
(51) Int. Cl.: H05K 1/02, H05K 1/03, H05K 3/28

(54) **A METHOD OF PRODUCING STRETCHABLE CLOTHING COMPRISING ELECTRONICS BY STACKING LAYERS, AND CLOTHING**

(30) Priority: 05.02.2015 NL 2014235
(71) Applicant: ELITAC B.V., 2012 BZ Haarlem (NL)
(72) Inventor: Vos, Wouter Karel, 3812 HD Amersfoort (NL); Bicknese, Bram Simon, 3521 VE Utrecht (NL); Abbema, Anneke Hendrica Petra Maria, 3022 DK Rotterdam (NL)
(74) Representative: Klavers, Cornelis

(57) **Abstract**

Method of producing stretchable clothing comprising electronics, comprising the steps of: (1) stacking on top of each other, at least: a first textile layer (7), a first encapsulating layer (8),
an electronics layer (9) comprising an at least partly stretchable electrically conductive structure comprising at least one electronic device, at least one electrical wire extending from the electronics layer, and a second encapsulating layer (10), (2) mechanically attaching the adjacent layers to each other, wherein all electrical wires from the electronics layer are extending in the same direction as said electronics layer at and near the position where they leave or arrive at the electronics layer. The first encapsulating layer, the second encapsulating layer and the electronics layer may be laminated into a first assembly before the first textile layer is laminated to said first assembly. A second textile layer may be attached to the second encapsulating layer.

## Description

The present invention relates to a method of producing stretchable clothing comprising electronics by stacking layers, and clothing.

In particular, the invention relates to a method of producing stretchable clothing, comprising the steps of:
(1) stacking on top of each other, at least:
   a first textile layer,
   a first encapsulating layer,
   an electronics layer comprising an at least partly stretchable electrically conductive structure comprising at least one electronic device,
   at least one electrical wire arriving at the electronics layer, and
   a second encapsulating layer, and
(2) mechanically attaching the adjacent layers to each other.

A similar method is known from WO2014124986A1, wherein a method of integrating a stretchable interposer layer with a textile layer is disclosed, the stretchable interposer layer comprising a stretchable electrically conductive structure with at least one contact pad for establishing at least one electrically conductive path towards the textile layer. The interposer layer is embedded in two encapsulating layers and mechanically attached by an encapsulating layer to a textile layer comprising a plurality of yarns, at least one of which is an electrically conductive yarn. Electrical connections are established between these conductive yarns of the textile and conductive pads of the interposer layer.

The known method allows for the production of pieces of clothing. However, it has as a disadvantage that it is laborious, in particular when reliable operation of the electronics is required. As such, the pieces of clothing created using the method are only affordable for markets where price is not the primary criterion.

The invention aims to alleviate this disadvantage. In particular, the invention aims to provide a method of the type described in the preamble that is improved, in particular with respect to requiring a reduced amount of effort, more in particular while still allowing for a high reliability of the resulting clothing.

The invention realizes this goal by the method having the characterizing features of claim 1.

In the method according to the invention, all electrical wires that are present extend in the same direction as the electronics layer where they leave this layer. In other words, no electrical wires, or conductive connections, are extending laterally from the electronics layer into or through the first textile layer and the first and second encapsulating layer to make contact therewith or to run there through. The term "wire" comprises not only wires such as bendable wires possibly provided with insulation material, but also other connections comprising conducting lines, such as present in electrical connectors. The phrase "wire arriving at the electronics layer" refers to a wire that does not lie entirely in the electronics layer, such as wires on a printed circuit board in the electronics layer usually do, but that lies partly outside that layer.

As a result, in combination with the fact that the electronics layer is usually substantially flat during production, but may have some degree of curvature, it becomes possible to simply lay the various layers, including the completed electronics layer, on top of each other without the need for a precise mutual alignment of these layers, as would be needed in the state of the art to allow wires to run through openings in the textile or encapsulation layers or to allow contact to be made between the textile (provided with conducting elements, such as printed wires) and the electronics. Such an alignment would be difficult and expensive. This is even more the case in situations where parts of the clothing, e.g. layers, also need to be aligned with other parts of the clothing or external objects, such as often occurs at edges of the clothing.

It is noted that the textile layer and encapsulation layers do not necessarily have to be continuous. As a first example, they may each be constituted by two or more layer segments, each segment covering a part of the surface and together covering the entire surface or almost the entire surface. For example, for practical reasons part of the wiring between components in the electronics layer may be covered with a prefabricated encapsulation layer, and the rest of the components may be covered with an encapsulation layer after the electronics layer is created from wiring and components. Preferably, when a layer is divided into segments, the segments are attached to each other, e.g. by gluing or lamination. As a second example, one or more of the textile and encapsulating layers may have an opening, e.g. in a part where the electronics layer has neither wiring nor components.

Of course, a precise alignment among layers may also be avoided by using large openings or large contact points, but both of these limit the possibilities with respect to sizing of the clothing. In particular, the elasticity or stretch of the electronics on one hand and the textile and/or encapsulating layers on the other hand, will differ and hinder the alignment.

The invention is advantageously applied in the case where the electronics layer comprises tactile actuators, since such devices do not require contact with the human skin, as opposed to certain sensors, and may thus well be left without connections to the textile layer or there through, at least regarding sensors. It is necessary however, for tactile actuators, and also for some types of sensors, to be pressed somewhat against the skin, in order to be sensible; a certain stretchability of the clothing makes this pressing possible. The stretchability also takes away the need to produce tailor made clothing for all sizes of persons; having a few standard sizes suffices. However, the stretchability should remain limited in order to provide sufficient pressing force.

It will be clear that it is still necessary to produce the electronic circuitry, which will need some alignment activities, but this may be done before the stacking step and with readily available tools, and is likely to be simpler than alignment of circuitry with textile, as the sizes of the electronic components and wiring will be better defined than the sizes of textile, especially when the circuitry is covered with a layer of PU-film or similar, or the circuitry is sandwiched between such film.

In an embodiment, first the first encapsulating layer, the second encapsulating layer and the electronics layer are laminated into a first assembly, and next the first textile layer is laminated to said first assembly.

In this manner, the electronics may be easily preassembled, possibly at another location or factory, and then be transported safely as a semi-finished product, and finally combined with the textile layer.

In an embodiment of the method, the first and/or second encapsulating layer comprises a film (19) arranged over at least the stretchable electrically conductive structure and a conforming coating (19) at the height of non-stretchable components which conforming film extends over and beyond said non-stretchable components in order to cover the electrically conductive structure in the electronics layer.

This has the advantage of a gradual transition of the stretchability between the various components (such as wiring, printed circuit board and actuators, etc) in the electronics layer, and consequently a higher reliability of the resultant stretchable liner. Moreover, it is possible to make the encapsulating layer watertight and/or protective against dirt, moisture, temperature extremes, chemicals, and the like.

The term conforming coating refers to a polymeric coating which conforms to the contours of a printed circuit board to protect the board's components. The coating may be brushed, sprayed, dipped or deposited. Examples of conforming coating are acrylics, silicones, synthetic rubber and urethanes.In an advantageous embodiment, a second textile layer is positioned on and attached to the second encapsulating layer. A second textile layer, on the opposite side of the first textile layer, with respect to the electronics layer, allows for a wider range of applications, such as in clothing used in products to be worn on the human body. The second layer increases the wearing comfort and may protect the electronics.

In a preferred embodiment, the first textile layer has an elasticity that is more than 3 times as high as the combined elasticity of the other layers in the stack, preferably more than 5 times.

When the clothing is worn with the first layer against the body of a person or animal, the other layers than the first layer provide a sufficiently high force for keeping the actuators pressed against the skin. Meanwhile, the relatively high elasticity of the first textile layer allows for a sufficient contact between tactile devices and the skin.

In an embodiment, the total elasticity of the layers, excluding the electronics layer, in the direction of the layers, per unit area of the cross-section of the layers, varies within each direction less than 100%, preferably less than 50% and more preferably less than 25%. This allows for a relatively even division of the stretching action, and hence for less risk of tearing a layer or parts thereof or therein.

In a preferred embodiment, the encapsulating layer comprises an adhesive, such as PU.

By having one of these materials as an adhesive, it becomes possible to mechanically attach the several layers to each other by applying heat at a temperature low enough for various textiles as well as electronics, meanwhile enabling a faster production process than glue would.

A further embodiment of the method comprises the step of adding a water-resistant coating between the electronics layer and at least one of the first textile layer and the second textile layer. For a simple and effective protection, the coating is positioned directly on the electronics layer. For each of these layers, no precise alignment is required, thus allowing for maintaining the high efficiency of the method of the invention.

Advantageously, the encapsulating layer comprises the water-resistant coating.

In this manner, no separate encapsulating layer and water-resistant electrically isolating layer are required but these layers are integrated, which simplifies both the procedure and the resulting product.

The invention also relates to stretchable clothing according to claim 10, addressing the same technical problem as the method above, i.e. it allows for an efficient method of producing such clothing.

The invention will now be illustrated on the basis of a preferred embodiment, referring to the accompanying drawings and merely as an illustration of the invention and not in limitation thereof. In the drawings, similar parts are given similar reference numerals. In the drawing:

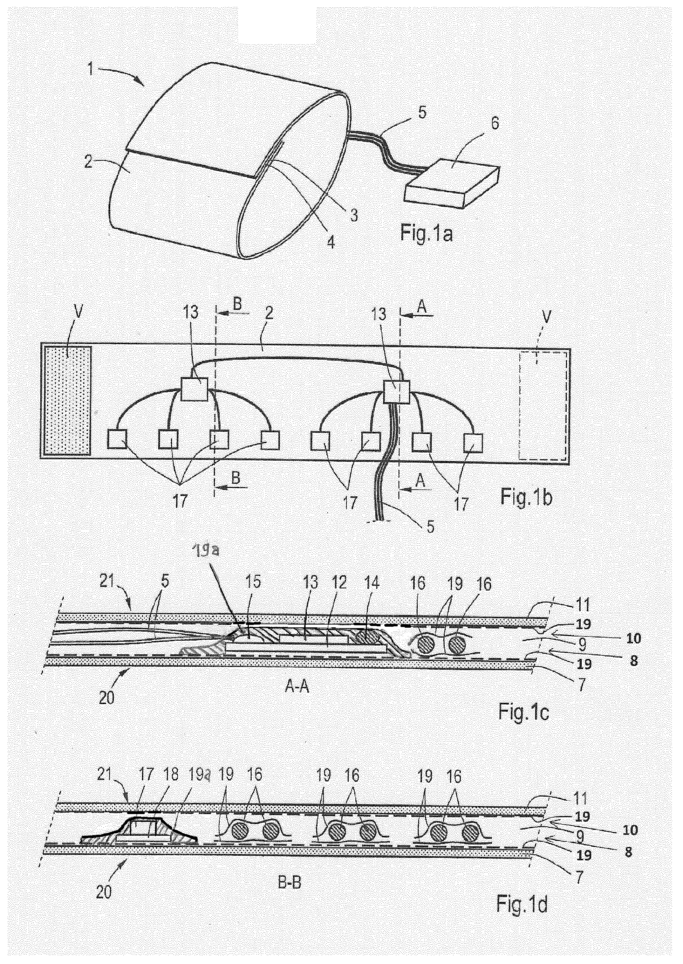

Figure 1a shows schematically a perspective view of a stretchable tactile belt, comprising clothing according to the invention,
Figure 1b shows a top view of the tactile belt of Figure 1a, the layers above the electronics layer removed,
Figure 1c shows schematically a cross-sectional view of the clothing of Figure 1a, seen over the line A-A in Figure 1b, and
Figure 1d shows schematically a cross-sectional view of the clothing of Figure 1a, seen over the line B-B in Figure 1b, and

In Figure 1a, a tactile belt 1 to be worn around the waist is shown, which belt 1 serves to provide its user with directional information during a walk, in other words for informing its user in which direction he/she should continue his/her walk for reaching a given geographical destination. The belt 1 comprises a strip of clothing 2, by nature stretchable, having Velcro (V) on its both ends 3, 4 by which it is possible to fix these ends 3, 4 to each other when the strip of clothing 2 is wrapped around the waist of a person. Inside is circuitry including two rows of each four tactile actuators 17. A pair of wires 5 extends outside the belt to a battery 6.

In Figure 1b, an electronics layer 9 is schematically shown, on top of a first encapsulation layer 8 and a first textile layer 7; for clarity a second encapsulation layer 10 and second textile layer 11 that are part of the belt 1 are removed.

The cross-sections of Figure 1c and Figure 1d show the first textile layer 7, the first encapsulating layer 8, the electronics layer 9, the second encapsulating layer 10, and the second textile layer 11, positioned on top of each other in the order mentioned. The first encapsulating layer 8 is made of PU and uninterrupted, i.e. continuous. The electronics layer 9 comprises a printed circuit board 12, with an integrated circuit (IC) 13 mounted thereon, and a resistor 14, the two wires 5 attached by soldering to the circuit board 12 at soldering points 15 (only one visible) and extending, except at the two soldering points 15, in the same direction as the electronics layer near the soldering points 15, i.e. in the plane of the electronics layer.

The electronics layer 9 further comprises wires 16 to tactile actuators 17, the latter mounted on small individual circuit boards 18. Below and above the wires 16 are PU films; the assemblies of wires 16 and their two surrounding PU films are prefabricated before using them in the stack 21 of layers that constitutes the clothing.

The second encapsulating layer 10 is made of the PU films 19 that cover the wires 16 and of PU films that cover the tactile actuators 17 and the printed circuit board 12. The upper one of the PU films 19 extends along the full length of the strip of clothing 2. After lamination, the PU films 19 above the electronics layer together form one water-resistant and electrically isolating encapsulation layer 11. The printed circuit board 12 and the tactile actuators 17, being non-stretchable components, are covered with a conforming coating 19a before the PU films are added, for improving the robustness and reliability of the belt 1. The conforming coating 19a extends over and beyond these components and thus covers the electrically conducting structure in the electronics layer to form a water tight encapsulating layer that also accommodates for variations in stretchability. The PU film 19 is interrupted above the printed circuit board 12, but this film 19 and the coating 19a overlap to maintain water tightness.

Figures 1c and 1d show the belt 1 in an unfinished state; its layers 7-11 still need to be pressed together and laminated by adding heat during the pressing.

The second textile layer 11 has a higher stiffness, or lower elasticity, than the first textile layer, in order to allow the belt 1 to be in good contact with the human waist and to make the eight tactile actuators 17 sensible for the person bearing the belt 1. The elasticity of the first textile layer 7 is approximately one third of the elasticity of the other layers 8, 10 and 11 together; the electronics layer 9 is not taken into account in this calculation.

The edges 20 of the stack 21 thus created are stitched, for preventing wear.

The belt 1 is created in the following subsequent steps, following the method of the invention:
s1: Provide each of the wires 16 with two PU films 19,
s2: provide the printed circuit boards 12 and 17 with their components,
s3: layout the printed circuit boards 12, actuators 17 and wires 5, 16,
s4: attach the wires 5 and 16 to the printed circuit boards 12, actuators 17, by soldering; position therein the wires 16, with their PU films 19,
s5: lay the first textile layer 7 down on a flat surface,
s6: put the first encapsulating layer 8 on top of the first textile layer 7,
s7: put the electronics layer 9 as a whole on top of the first encapsulating layer 8,
s8: position the two further PU films 19 on top of the printed circuit board 12 and the tactile actuators 17 (this step is just to provide more reliability and may be left out, in a variant),
s9: lay the second textile layer 11 on top of the other layers,
s10: press the layers 7-11 together, while adding heat, in a manner known in the art, to laminate them together, and
s11: cut and stitch the edges 20.

All the above steps may be done manually and by a machine. Manual work may still be more efficient than machine work, in steps s3 and s7, for small series. In the other steps, machine handling is preferred, if not for cost then at least for quality and speed.

In this embodiment, the electronics is configured to obtain instructions for activation of each of the eight tactile actuators from a digital computer by means of wireless data communication. The two wires 5 are solely for providing power to the electronics. In an alternative embodiment, the power is also obtained wirelessly, in particular by means of cooperating inductive loops within the electronics layer and outside the belt 1. In the embodiment without any wires leaving the belt 1, the step s11 is further simplified.

### Reference numerals:

- Belt: 1
- Strip of clothing: 2
- Velcro: V
- Ends: 3, 4
- Wires: 5
- Battery: 6
- First textile layer: 7
- A first encapsulating layer: 8
- An electronics layer: 9
- A second encapsulating layer: 10
- A second textile layer: 11
- Printed Circuit board: 12
- IC: 13
- Resistor: 14
- Soldering point: 15
- Wire: 16
- Tactile actuator: 17
- Circuit board: 18
- PU film: 19
- Conforming coating: 19a
- Edges: 20
- Stack: 21

## Claims

1. Method of producing stretchable clothing comprising electronics, comprising the steps of:
(1) stacking on top of each other, at least:
a first textile layer (7),
a first encapsulating layer (8),
an electronics layer (9) comprising an at least partly stretchable electrically conductive structure comprising at least one electronic device,
at least one electrical wire arriving at the electronics layer, and
a second encapsulating layer (10),
(2) mechanically attaching the adjacent layers to each other, **characterized in that**
all electrical wires arriving at the electronics layer are extending in the same direction as said electronics layer at and near the position where they arrive at the electronics layer.

2. Method of producing clothing according to claim 1, wherein first the first encapsulating layer, the second encapsulating layer and the electronics layer are laminated into a first assembly, and
next the first textile layer is laminated to said first assembly.

3. Method of producing stretchable clothing according to claim 1 or 2, wherein the first and/or second encapsulating layer comprises a film (19) arranged arranged over at least the stretchable electrically conductive structure and a conforming coating (19a) at the height of non-stretchable components which conforming coating extends over and beyond said non-stretchable components in order to cover the electrically conductive structure in the electronics layer.

4. Method of producing clothing according to claim 1, wherein a second textile layer is positioned on and attached to the second encapsulating layer.

5. Method of producing clothing according to one of the preceding claims, wherein the at least one electronic device comprises at least one tactile stimulation device, and the first textile layer has an elasticity that is more than 3 times as high as the combined elasticity of the other layers in the stack, preferably more than 5 times.

6. Method of producing clothing according to one of the preceding claims, wherein the total elasticity of the layers, excluding the electronics layer, in the direction of the layers, per unit area of the cross-section of the layers, varies within each direction less than 100%, preferably less than 50% and more preferably less than 25%.

7. Method of producing clothing according to one of the preceding claims, wherein at least one of the encapsulating layers comprises an adhesive, such as PU.

8. Method of producing clothing according to one of the preceding claims 1-7, comprising the step of adding a water-resistant coating between the electronics layer and at least one of the first textile layer and the second textile layer.

9. Method of producing clothing according to claim 8, wherein at least one of the encapsulating layers comprises the water-resistant coating.

10. Stretchable clothing comprising electronics, comprising:
a first textile layer,
an electronics layer comprising an at least partly stretchable electrically conductive structure comprising at least one electronic device,
at least one electrical line arriving at the electronics layer,
wherein the first textile layer is mechanically attached to the electronics layer with the interposition of a first encapsulating layer, and
a second encapsulating layer that is mechanically attached to the opposite side of the first encapsulating layer of the electronics layer, and a second textile layer, which second layer is positioned on and attached to the second encapsulating layer,
**characterized in that**
all electrical wires arriving at the electronics layer are extending in the same direction as said electronics layer at and near the position where they arrive at the electronics layer.

11. Stretchable clothing according to claim 10, wherein the encapsulating layer comprises a film (19) arranged over at least the stretchable electrically conductive structure and a conforming coating (19a) at the height of non-stretchable components which conforming coating extends over and beyond said non-stretchable components in order to cover the electrically conductive structure in the electronics layer.

12. Stretchable clothing according to claim 10 or 11, wherein the total elasticity of the layers, excluding the electronics layer, in the direction of the layers, per unit area of the cross-section of the layers, varies within each direction less than 100%, preferably less than 50% and more preferably less than 25%.
